# EUROPEAN PATENT APPLICATION

(11) **EP 1 752 828 A1**
(43) Date of publication of application: **14.02.2007**
(21) Application number: 05734583.7
(22) Date of filing: 20.04.2005
(51) Int. Cl.: G03F 7/32, H01L 21/027

(54) **RINSE SOLUTION FOR LITHOGRAPHY**

(30) Priority: 23.04.2004 JP 2004129095; 01.09.2004 JP 2004254939; 01.12.2004 JP 2004349197
(71) Applicant: TOKYO OHKA KOGYO CO., LTD., Kawasaki-shi, Kanagawa 211-0012 (JP)
(72) Inventor: KOSHIYAMA, Jun, c/o TOKYO OHKA KOGYO CO., LTD., Kawasaki-shi, Kanagawa 2110012 (JP); WAKIYA, Kazumasa, c/o TOKYO OHKA KOGYO CO., LTD., Kawasaki-shi, Kanagawa 2110012 (JP); KANEKO, Fumitake, c/o TOKYO OHKA KOGYO CO., LTD., Kawasaki-shi, Kanagawa 2110012 (JP); MIYAMOTO, Atsushi, c/o TOKYO OHKA KOGYO CO., LTD., Kawasaki-shi, Kanagawa 2110012 (JP); SAWADA, Yoshihiro, c/o TOKYO OHKA KOGYO CO., LTD., Kawasaki-shi, Kanagawa 2110012 (JP); TAJIMA, Hidekazu, c/o TOKYO OHKA KOGYO CO., LTD., Kawasaki-shi, Kanagawa 2110012 (JP)
(74) Representative: Beetz & Partner
(86) International application number: PCT/JP2005/007503
(87) International publication number: WO 2005/103830

(57) **Abstract**

A novel rinse solution for lithography to be used for suppressing contraction of a pattern and a method for forming a resist pattern using the rinse solution are provided, by reducing product surface defects of a photoresist pattern and providing the photoresist pattern with resistance to electronic beam irradiation. The rinse solution for lithography composed of a solution including a water-soluble resin having a nitrogen atom in a molecular structure is prepared. The resist pattern is formed with the rinse solution by performing (A) a process of providing a photoresist film on a board, (B) a process of selectively exposing the photoresist film through a mask pattern, (C) a process of performing post exposure bake (PEB), (D) a process of alkaline development, and (E) a process of treatment with the rinse solution for lithography.

## Description

### TECHNICAL FIELD

The present invention relates to a rinse solution for lithography capable of, by being brought into contact with a resist after an image-forming light exposure followed by a development treatment, decreasing the defects after the rinse treatment, preventing pattern falling in the water rinse, and being effective in suppression of the shrinkage of the pattern caused by electron beam irradiation by improving the electron beam resistance as well as to a resist pattern forming method by using the same.

### BACKGROUND TECHNOLOGY

Along with the trend in recent years toward compactness and high integration of semiconductor devices, the light sources for the fine working thereof are also under a trend of shift to shorter wavelength ones from traditional UV light to the g-line (436 nm) capable of forming a resist pattern of higher resolution to the i-line (365 nm) and from the i-line to the KrF excimer laser (248 nm) to accomplish shorter and shorter wavelengths leading to the current ArF excimer laser (193 nm), F₂ excimer laser (157 nm) and further electron beams such as EB and EUV shifter as a major current while developments of the process and resist materials are under progress at a high pace in order to comply with these short-wavelength light sources.

Conventional photoresists are required to have: for instance, improved sensitivity, pattern resolution, heat resistance, focusing depth latitude, cross sectional profile of a resist pattern, aging stability resulting in the deterioration of the shape of the resist pattern due to contamination with amine and the like in a period between light exposure and post-exposure baking (PEB) and substrate dependency which changes are caused in the cross sectional profile of the resist pattern depending on various coating films on the silicon wafer such as insulating films including silicon nitride (SiN) films, semiconductor films including polycrystalline silicon (poly-Si) films and metallic films including titanium nitride (TiN) films. These requirements have been solved to some extent, but a defect which is a particularly important issue has many problems remaining unsolved.

The defect means a mismatch between a resist pattern and a photomask pattern, which is detected when a resist pattern after having been developed is examined from right above with a surface defect observation instrument, for instance, the mismatch like a difference between shapes of the patterns, occurrence of scums and contaminants, irregular coloring and coalescence between the patterns. The yield of the semiconductor devices decreases as the number of defects increases so that, even though the photoresist has the adequate resist characteristics as described above, defects make it difficult for the semiconductor devices to be effectively mass produced, while the problems thereof remain unsolved.

Various causes for the defect can be considered, some of which are the production of microbubbles in the development, and the re-deposition in the rinsing step of once removed insoluble substances.

As a method for decreasing such defects, an improving method of changing the composition itself of a positive-working resist composition used in pattern formation (JP2002-148816A) is proposed, but such a change of the composition is not preferable because the process itself need be changed.

A method of applying a defect treatment agent containing a hydrophobic group and a hydrophilic group, that is a surface active agent, in the formation of the resist pattern is also proposed (JP2001-23893A), but the method has a problem of making the top of the resist pattern round to lower the orthogonality in the cross sectional profile, and further of film thickness reduction of the resist layer during the treatment. In a semiconductor manufacturing plant, besides, a developer solution is usually supplied through a collective pipeline so that, when using various resists, it is necessary to change the treatment agent in correspondence to each resist, and to clean the inside of the pipeline after each run. Consequently, this method is unsuitable.

Furthermore, a method of reducing the defects by using a developer solution containing an organic base with no metallic ions and a nonionic surface active agent as the main component, in a development step of photolithography (JP2001-159824A) is known but shows no sufficient effects to decrease the defects along with the above-mentioned inconveniences.

On the other hand, a method of reducing the defects by treating before post-exposure baking treatment, with the use of an aqueous solution having a pH of 3.5 or lower which contains low-volatile aromatic sulfonic acid with a molecular weight of 200 or larger (JP2002-323774A) is known but cannot reduce the defects satisfactory enough for industrialization.

### DISCLOSURE OF THE INVENTION

The present invention has been made with an object, under these circumstances, to provide a novel rinse solution for lithography which is used for forming a photoresist pattern in order to decrease the surface defects of a product, so-called a defect, to inhibit pattern falling in rinse with water and to impart resistance to the resist by electron beam irradiation so as to suppress the shrinkage of the pattern as well as a resist pattern forming method using the same.

As a result of their extensively continued studies for developing a treatment solution capable of decreasing the defects in the resist pattern obtained without affecting the effect of the rinse treatment *per se* and capable of imparting electron beam resistance to the resist resulting in an improvement of the yield, the inventors have arrived at a discovery that a solution containing a water-soluble resin having a nitrogen atom in the molecular structure is effective in decreasing the defects, in preventing pattern falling in the course of water rinse and imparting electron beam resistance to the resist and that, in the resist pattern formation, when the photoresist film after the alkali-development treatment is treated with the afore-mentioned solution, the good form of the resist pattern can be retained and defects can be decreased without causing the phenomena of dissolution and swelling along with suppression of pattern shrinkage when electron beam irradiation is undertaken leading to the present invention on the base of this discovery.

Namely, the present invention provides a rinse solution for lithography characterized by comprising an aqueous solution of a water-soluble resin containing a nitrogen atom in the molecular structure as well as a method for the formation of a resist pattern characterized by conducting:
(A) a step of forming a photoresist film on the surface of the substrate;
(B) a step of selectively light-exposing the photoresist film through a photomask pattern in order to form a latent image;
(C) a step of subjecting the light-exposed photoresist film mentioned above to a post-exposure baking treatment (hereafter called PEB treatment);
(D) a step of alkali-development of the above-mentioned photoresist film after the PEB treatment; and
(E) a step of treating the developed photoresist film mentioned above with the rinse solution for lithography mentioned above.

A water-soluble resin used in the present invention needs to use a water-soluble resin containing a nitrogen atom in the molecular structure.
The nitrogen atom can be contained in the functional molecular chain of a polymer or can be contained in the side chain as a nitrogen-containing substituent.

The water-soluble resin containing a nitrogen atom in the functional molecular chain is exemplified, for example, by a polymer of lower alkyleneimines or a copolymer of a lower alkyleneimine and another monomer capable of forming a water-soluble polymer by itself of which polyethyleneimine is particularly preferred in respect of easy availability thereof.

The polyethyleneimine can be easily produced, for example, by polymerization of ethyleneimine under the presence of an acidic catalyst such as carbon dioxide, chlorine, hydrogen bromide, *p*-toluenesulfonic acid and the like and it is available as a commercial product.

The water-soluble resin containing a nitrogen-containing substituent in the side chain is exemplified by a polymer or a copolymer of unsaturated hydrocarbons having amino groups or substituent amino groups or a nitrogen-containing heterocyclic group. The polymer of unsaturated hydrocarbons having amino groups is exemplified, for example, by polyallylamine. The polyallylamine can be easily obtained by, for example, heating allylamine hydrochloride under the presence of a radical polymerization initiator.

The water-soluble resin containing a nitrogen-containing substituent used in the present invention is preferably a water-soluble resin containing a monomeric unit having a nitrogen-containing heterocyclic group represented by the general formula, 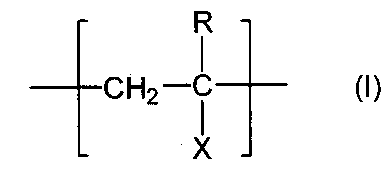 (R in the formula is a hydrogen atom or a methyl group and X is a nitrogen-containing heterocyclic group).

Examples of the nitrogen-containing heterocyclic group denoted by X in the above given general formula (I) include, for example, a pyrrolyl group, imidazolyl group, pyrazolyl group, thiazolyl group, oxazolyl group, isoxazolyl group, pyridyl group, pyrazyl group, pyrimidyl group, pyridazyl group, triazolyl group, indolyl group, quinolyl group, butyrolactam group, caprolactam group and the like and also include other nitrogen-containing heterocyclic groups.

The bonding position of these heterocyclic groups is not particularly limitative and can be at a nitrogen atom or can be at a carbon atom.

The water-soluble resin containing the monomeric units having such a nitrogen-containing heterocyclic group can be prepared by, for example, polymerizing or copolymerizing a monomer having a nitrogen-containing heterocyclic group expressed by the general formula 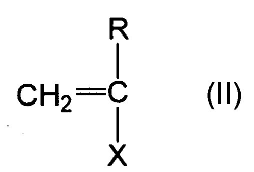 (R and X in the formula have the same meanings as before) or a mixture thereof with a monomer capable of singly forming a water-soluble polymer but containing no nitrogen atom. This polymerization or copolymerization can be performed by a method conventionally used for the preparation of polymers or copolymers such as solution polymerization method, suspension polymerization method and the like.

Preferable ones among the monomers represented by the above-given general formula (II) include vinyl imidazole, vinyl imidazoline, vinyl pyridine, vinyl pyrrolidone, vinyl morpholine and vinyl caprolactam, of which vinyl imidazole, vinyl imidazoline and vinyl pyrrolidone are particularly preferable.

The above-mentioned monomers capable of singly forming a water-soluble polymer but containing no nitrogen atoms usable here include, for example, vinyl alcohol, hydroxyalkyl esters of acrylic acid or methacrylic acid and the like. These monomers can be used either singly or can be used as a combination of two kinds or more.

The proportion in this case between the monomer having a nitrogen-containing heterocyclic group and the monomer capable of singly forming a water-soluble polymer is selected in the range of 10:0 to 1:9 or, preferably, 9:1 to 2:8 by mass. When the proportion of the monomer having a nitrogen-containing heterocyclic group is smaller than above, the adsorbing performance onto the resist surface is decreased so that the desired characteristic or, namely, pattern-falling preventing power is decreased. The mass-average molecular weight of this copolymer is selected in the range of 500 to 1500000 or, preferably, 1000 to 50000. As this copolymer, those containing a cationic monomer are particularly preferred.

Such a copolymer is marketed from, for example, BASF Corp. [product name LUVITEC VPI55 K72W and Sokalan HP56] and polyvinylimidazoline is marketed from TOSOH CORP.

The concentration of the above-described water-soluble resin in the rinse solution for lithography of the present invention is selected in the range of at least 0.1 ppm or, namely, at least 0.00001 % by mass based on the total amount of the rinse solution or, preferably, 0.5 ppm or, namely, at least 0.00005% by mass based on the total amount of the rinse solution in the case of use with an object to decrease the defects or with an object to suppress the shrinkage of the pattern caused by electron beam irradiation by improving the electron beam resistance but, in the case of use with an object to prevent pattern falling in the course of water rinse, it should be selected in the range of at least 10 ppm or, namely, at least 0.001 % by mass or, preferably, at least 0.01 % by mass based on the total amount of the rinse solution.

While the concentration of the water-soluble resin has no particular upper limit, an unduly high concentration causes increases in the used volume of pure water and in the water-rinse time for the succeeding water rinse so that it is selected in the range, usually, of 10% by mass or lower or, preferably, 5% by mass or lower.

The rinse solution of the present invention for lithography is employed for the treatment of a substrate at the stage following the alkali development of the resist film on the substrate after the image forming light exposure. The treatment is undertaken by dipping the substrate bearing the resist film in this treatment solution or by applying or spraying this rinse solution onto the resist film. A treatment time of 1 to 30 seconds would be sufficient with this rinse solution.

The rinse solution of the present invention for lithography can be prepared by dissolving, in water, the above-described water-soluble resin containing the monomeric units having a nitrogen atom in the molecular structure and it is optional there according to desire that the water is admixed with a water-miscible organic solvent to such an extent as not to affect the object.

It is optional according to desire that the rinse solution is admixed with an acid to be rendered acidic or admixed with an amine compound or a quaternary ammonium hydroxide to be rendered basic with a pH of 8 or higher. Addition of such compounds has an effect of preventing in-time degradation of the composition.

It is optional according to desire that the rinse solution contains a known surface active agent with an object of improving the coating adoptability. Examples of such a surface active agent include N-octyl-2-pyrrolidone and the like.

As a result of the enhanced rinse efficiency on the resist pattern surface by the treatment with the rinse solution of the present invention, an effect can be obtained for generally decreasing the defects regardless of the modes. Furthermore, the rinse solution of the present invention has a power of decreasing the contact angle on the resist pattern surface so that an effect is obtained in further decreasing the defects of the re-deposition type by preventing redeposition of the resist debris once removed from the resist pattern and floating in the rinse solution. And, this contact angle is continuedly retained during the rinse treatment with pure water which is succeedingly undertaken according to need.

The above-described rinse solution is used, in particular, satisfactorily in the formation of a resist pattern by using a photoresist film. The forming method of the resist pattern in this case comprises the steps (A) to (E) below.

Firstly, the step (A) is a step in which a photoresist film is formed on a substrate.

Silicon wafers are usually employed as the substrate. The photoresist compositions used for the formation of a photoresist film can be known ones.

In step (A), a substrate such as a silicon wafer is coated with a solution of a known photoresist composition on a spinner and the like and subjected to a drying treatment to form a photoresist film.

Nextly in step (B), the photoresist film formed in step (A) is subjected selectively to light-exposure treatment through a photomask pattern to form a latent image followed by, in step (C), a PEB treatment. These step (B) and step (C) can be performed in just the same way as in the resist pattern-forming method by using a conventional resist.

The photoresist film thus subjected to the PEB treatment is then, in step (D), subjected to an alkali development treatment. This alkali development treatment is conducted, for example, by using an aqueous solution of tetramethylammonium hydroxide in a concentration of 1-10% by mass or, preferably, 2.38% by mass (hereinafter abridged to a TMAH aqueous solution).

In step (E) undertaken following this step (D), the photoresist film after the alkali development treatment is treated with a rinse solution for lithography containing a water-soluble resin having a nitrogen atom in the molecular structure.

Since semiconductor devices are usually mass-produced and the throughput is an important factor, it is preferable that the time taken for the rinse treatment should be as short as possible. The treatment time is selected within a range of 1 to 30 seconds.

In step (E), it is advantageous to use an allylamine polymer as the water-soluble resin contained in the rinse solution because of the possibility of further decreasing the aforementioned treatment time.

When rinse is conducted with a rinse solution for lithography containing a polyallylamine as the water-soluble resin, an advantage is obtained that water-break or, namely, water shake-off can be improved in the treatment to follow optionally undertaken with a rinse solution containing a water-soluble fluorocarbon compound for increasing the contact angle of the resist surface with pure water. Though not limited to a particular molecular weight range, it is preferable that the polyallylamine in this case has a molecular weight in the range of 1000 to 60000. When the content of the polyallylamine in this rinse solution is increased to certain extent, the shake-off time can be shortened to about 3 seconds length which is about 1/3 as compared with about 10 seconds in the use of other water-soluble resins.

The treatment in step (E) with the rinse solution for lithography is conducted, for example, by applying or spraying the rinse solution to the resist pattern surface or by dipping the resist pattern in the rinse solution and it is advantageous to undertake coating, for example, by rotary coating without necessity of setting a separate step on the production line of semiconductor devices in view of the high throughput.

In the resist pattern forming method according to the present invention, step (E) can optionally be followed according to desire by step (F) for rinse with pure water.

While it is usually one of the reasons of defects in the ordinary resist pattern formation that the alkali-insoluble ingredient in the resist composition precipitates out in the course of the water rinse after the alkali development to be deposited on the surface of the positive-working resist film after the resist pattern formation, it is presumable in the method of the present invention that re-deposition of the alkali-soluble matter in the resist onto the resist pattern surface can be prevented by undertaking, after the development, the treatment with the rinse solution of the present invention for lithography imparting a hydrophilic property to the resist pattern surface leading to suppression of the re-deposition-type defects in particular.

While the resist pattern surface after treatment with the method of the present invention may have a small contact angle of 40 degrees or smaller or, preferably, 30 degrees or smaller against pure water depending on the formulation of the compounding amounts, this can be modified to a high contact angle of 70 degrees or larger against pure water by a further treatment with a rinse solution containing a fluorine compound having solubility with alcoholic solvents such as, for example, water-soluble fluorocarbon compounds. By undertaking such a treatment, pattern falling can be effectively prevented to provide an advantage of producing high-quality products.

### BRIEF DESCRIPTION OF THE DRAWING

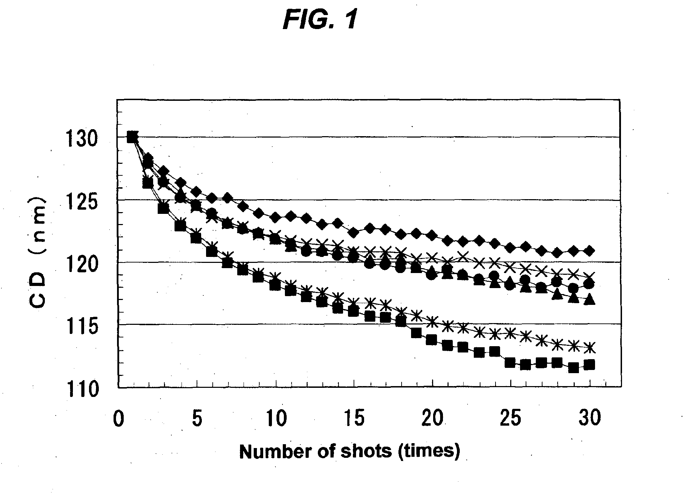

Figure 1 is a graph showing the relationship of the pattern width contraction in the resist pattern dimension with the number of shots in the examination of the rinse solution obtained in Example 3 on a scanning electron microscope.

### BEST MODE FOR CARRYING OUT THE INVENTION

Following is a description of the best mode for practicing the present invention by way of Examples but the present invention is never limited by these Examples.

Incidentally, the property values in each of the Examples were determined by the methods below.

### (1) Contact angle

Measurements were made by using a contact angle meter (manufactured by Kyowa Interface Science Co., Model CA-X150).

### (2) Number of defects

Measurements were made by using a surface-defects detector (manufactured by KLA-Tencol Corp., Model KLA-2131).

### (3) Shake-off time

Test specimens were prepared by coating a 6-inches silicon wafer with a positive-working resist (a product by Tokyo Ohka Kogyo Co., product name TARF-P6111) in a thickness of 180 nm and the same was treated, without undertaking any light exposure, with a 2.38% by mass aqueous TMAH solution (solution temperature 23 °C) for 60 seconds followed by application of the rinse solution under testing to the surface at 2000 rpm for 6 seconds and further application of pure water at 500 rpm for 3 seconds to record the time in seconds until complete shake-off at 1000 rpm.

### (4) Electron beam resistance

A line pattern of 130 nm width was formed on a silicon substrate and irradiation thereof was repeated 30 times to measure the line width by using a measuring SEM (manufactured by Hitachi High-Technologies Corp., Model S-9300).

### Example 1

An antireflection film having a film thickness of 77 nm was formed on a silicon wafer by coating with an antireflection filming agent (produced by Brewer Science, Inc., product name ARC 29A) followed by a heating treatment at 215 °C for 60 seconds.

This antireflection film was coated with a chemical-amplification positive-working photoresist prepared by dissolving a resinous ingredient expressed by the formula 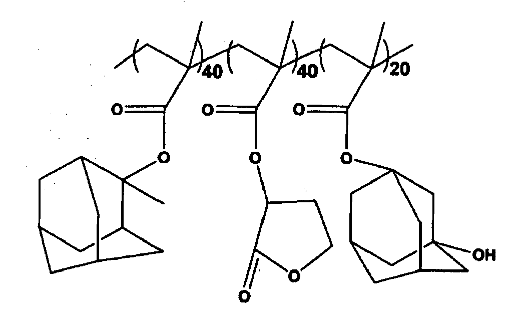 as a resinous component and, relative to the resinous component, 3.0% by mass of triphenylsulfonium perfluorobutane sulfonate and 0.35% by mass of triethanolamine in a mixed solvent of propyleneglycol monomethylether acetate and propyleneglycol monomethyl ether (mixing proportion=6:4) to give an overall solid concentration of 11 % by mass to form a photoresist film of 460 nm film thickness.

Onto the substrate having the thus formed photoresist film, a light exposure treatment was conducted with a light of 193 nm wavelength by using an ArF excimer stepper (a product by Nikon Corp., product name NSR-S302A) followed by a heating treatment at 130 °C for 90 seconds.

Nextly, a development treatment was conducted at 23 °C by using a 2.38% by mass aqueous TNAH solution taking 60 seconds.

In this way, a resist pattern of which the surface had a contact angle of 76 degrees was obtained.

In the next place, 0.1 % by mass aqueous solutions were prepared as the samples of rinse solution for lithography by using a polyvinyl imidazoline (PVI) and copolymers of vinyl pyrrolidone (VP) and vinyl imidazole (Vl) in mass proportions of 25:75, 50:50, 85:15 and 90:10.

Rinse treatments were undertaken by dripping these rinse solution samples for lithography at 500 rpm for 3 seconds onto the surface of the aforementioned resist pattern followed by rinse with pure water for 20 seconds. Table 1 in No. 1 to No. 5 shows the contact angles and the numbers of defects in the surfaces of the resist patterns obtained in this way. No. 6 is for the contact angle and the number of defects on the surface of the resist pattern before the rinse treatment.

**Table 1**

| No. | Monomer (mass proportion) | | Contact angle (degrees) | Number of defects |
|---|---|---|---|---|
| | VP | Vl | | |
| 1 | 0 | 100 | 27 | 12 |
| 2 | 25 | 75 | 23 | 5 |
| 3 | 50 | 50 | 25 | 9 |
| 4 | 85 | 15 | 29 | 15 |
| 5 | 90 | 10 | 30 | 18 |
| 6 | None | | 76 | 10000< |

### Example 2

A silicon wafer was coated with an antireflection filming agent (a product by Brewer Science, Inc., product name ARC 29A) and subjected to a heating treatment at 215 °C for 60 seconds to form an antireflection film of 77 nm film thickness. On this antireflection film, a photoresist film of 460 nm film thickness was formed by coating with a positive-working resist (a product by Tokyo Ohka Kogyo Co., product name TARF-P6111).

The substrate on which this photoresist film was formed was subjected to a light-exposure treatment with an exposure light of 193 nm wavelength by using an ArF excimer stepper (a product by Nikon Corp., product name NSR-S302A) followed by a heating treatment at 130 °C for 90 seconds.

After completion of the light exposure, a development treatment was undertaken at 23 °C taking 60 seconds by using a 2.38% by mass aqueous TMAH solution.

In the next place, a rinse treatment was undertaken, at 500 rpm for 3 seconds, by dripping a rinse solution for lithography (first rinse solution) consisting of a 0.1 % by mass aqueous solution of a polyallylamine (PAA), polyvinylimidazoline (PVI) or a copolymer of vinyl pyrrolidone and vinyl imidazoline in a mass proportion of 1:1 followed by a rinse treatment with pure water for 20 seconds and then a further rinse treatment was undertaken with a rinse solution (second rinse solution) of fluorine compound which was a 0.005% by mass aqueous solution of (C₃F₇SO₂)₂NH.

Table 2 shows the shake-off times of water from the resist patterns obtained in this way.

**Table 2**

| No. | Rinse solutions | | Shake-off times |
|---|---|---|---|
| | First | Second | |
| 1 | PAA | (C₃F₇SO₂)₂NH | 3 |
| 2 | PVI | (C₃F₇SO₂)₂NH | 7 |
| 3 | VP/VI | (C₃F₇SO₂)₂NH | 10 |

As is understood from this table, use of a polyallylamine is effective for shortening of the total tact of the process with a particularly increased liquid-removal rate.

### Example 3

A silicon wafer was coated with an antireflection filming agent (a product by Brewer Science, Inc., product name ARC29A) and subjected to a heat treatment at 215 °C for 60 seconds to form an antireflection film having a film thickness of 77 nm. A photoresist film of 460 nm film thickness was formed on this antireflection film by coating with a positive-working resist (a product by Tokyo Ohka Kogyo Co., product name TARF-P6111)

The substrate on which this photoresist film was formed was subjected to a light-exposure treatment with an exposure light of 193 nm wavelength by using an ArF excimer stepper (a product by Nikon Corp., product name NSR S-302A) followed by a heat treatment at 130 °C for 90 seconds.

After completion of the light exposure, a development treatment was undertaken at 23 °C taking 60 seconds by using a 2.38% by mass aqueous TMAH solution.

The thus obtained resist pattern was subjected to a rinse treatment by dripping, for 3 seconds at 500 rpm, with a rinse solution for lithography consisting of a 0.1 % by mass aqueous solution of a copolymer of vinyl pyrrolidone and vinyl imidazoline in a mass proportion of 1:1 (VP/Vl), polyallylamine (PAA), polyvinyl imidazoline (PVI) or polyethyleneimine followed by rinse with pure water for 20 seconds.

The thus rinse-treated resist pattern was subjected to a SEM (scanning electron microscope) examination for 1 to 30 shots. The resist pattern sizes in the SEM observation are shown in Figure 1. For comparison, the SEM observation was undertaken also for the case where the rinse treatment with the aqueous resin solution was omitted.

The symbols in the Figure indicate the followings.
◆ : VP/VI (molecular weight 1200000)
×: PAA (molecular weight 15000)
● : PVI (molecular weight 5000)
▲: VP/VI (molecular weight 10000)
*: polyethyleneimine (molecular weight 70000)
■: no resin

### Example 4

A resist pattern was obtained by subjecting a photoresist film formed on a silicon wafer by using TDUR-P3187 (a product by Tokyo Ohka Kogyo Co.) as the positive-working photoresist to the light-exposure and development treatments in the same manner as in Example 1.

In the next place, a rinse solution, which consisted of an aqueous solution containing a copolymer of vinyl pyrrolidone and vinyl imidazole (molar ratio 50:50) in a concentration of 50 ppm, was prepared and used for the treatment of the surface of the aforementioned resist pattern at 2000 rpm for 7 seconds followed by water rinse and drying to count the number of defects. The number of the defects in each of the cases was 1 % or less as compared with the number of defects when the treatment was undertaken only by using pure water as the rinse solution.

### Example 5

A resist pattern was obtained in the same manner as in Example 4 excepting for the use of TARF-P7066 (a product by Tokyo Ohka Kogyo Co.) as the positive-working photoresist.

In the next place, rinse solutions each consisting of an aqueous solution containing a copolymer of vinyl pyrrolidone and vinyl imidazole (molar ratio 50:50) in a concentration of 1 ppm or 50 ppm were prepared and they were used for the treatment of the surface of the aforementioned resist pattern at 2000 rpm for 7 seconds followed by water rinse and drying for counting of the number of defects. The numbers of the defects in this case were each 1% or less as compared with the numbers of the defects when the treatment was undertaken only by using pure water as the rinse solution.

### Industrial Utilizability

According to the present invention, it is possible that the defects occurring in the formation of a pattern by using a photoresist are decreased so as to improve the product yield and that resistance against electron beam is imparted so as to keep high dimensional controllability by reducing the shrinkage of the pattern by the electron beam irradiation. Further, an effect can be exhibited to prevent pattern falling when a solution of a fluorine compound such as a water-soluble fluorocarbon compound is used in combination as the rinse solution. Furthermore, the shake-off time of water in the succeeding water rinse can be shortened. Accordingly, the present invention can be employed in the manufacture of semiconductor devices such as LSis, ULSls and the like using a lithographic method.

## Claims

1. A rinse solution for lithography **characterized by** comprising an aqueous solution containing a water-soluble resin having a nitrogen atom in the molecular structure.

2. The rinse solution for lithography as claimed in claim 1 wherein the water-soluble resin is a water-soluble resin having a nitrogen-containing heterocyclic group.

3. The rinse solution for lithography as claimed in claim 2 wherein the water-soluble resin having a nitrogen-containing heterocyclic group is a water-soluble resin containing a constituent unit represented by the general formula 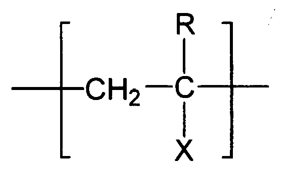 (R in the formula is a hydrogen atom or a methyl group and X is a nitrogen-containing heterocyclic group).

4. The rinse solution for lithography as claimed in claim 3 wherein the water-soluble resin is a polymer or a copolymer containing at least one kind of monomeric units derived from vinyl imidazole, vinyl imidazoline or vinyl pyrrolidone as the constituent units.

5. The rinse solution for lithography as claimed in any one of Claims 1 to 4 wherein the water-soluble resin has a mass-average molecular weight in the range of from 500 to 1500000.

6. The rinse solution for lithography as claimed in any one of Claims 1 to 5 which contains the water-soluble resin in a concentration of at least 0.1 ppm based on the total amount.

7. A method for resist pattern formation **characterized by** comprising:
(A) a step of forming a photoresist film on a substrate;
(B) a step of a light-exposure treatment on the said photoresist film through a photomask pattern for selectively forming a latent image;
(C) a step of subjecting the photoresist film after the light-exposure treatment to a post-exposure baking (PEB) treatment;
(D) a step of subjecting the photoresist film after the PEB treatment to an alkali-development treatment; and
(E) a step of treatment of the photoresist film after the development treatment with the rinse solution for lithography described in any one of Claims 1 to 6.

8. The method for resist pattern formation as described in Claim 7 which further comprises (F) a step of a rinse treatment by using pure water after undertaking the step (E).
